(19) Europäisches Patentamt / European Patent Office / Office européen des brevets

(11) **EP 2 156 202 B1**

(12) **EUROPÄISCHE PATENTSCHRIFT**

(45) Veröffentlichungstag und Bekanntmachung des Hinweises auf die Patenterteilung:
**27.12.2017   Patentblatt 2017/52**

(21) Anmeldenummer: **08748896.1**

(22) Anmeldetag: **11.04.2008**

(51) Int Cl.:
**G01R 27/32** *(2006.01)*          **G01R 35/00** *(2006.01)*

(86) Internationale Anmeldenummer:
**PCT/EP2008/002901**

(87) Internationale Veröffentlichungsnummer:
**WO 2008/154976 (24.12.2008 Gazette 2008/52)**

(54) **VERFAHREN UND VORRICHTUNG ZUR KALIBRIERUNG VON NETZWERKANALYSATOREN MIT EINEM KAMMGENERATOR**

METHOD AND DEVICE FOR THE CALIBRATION OF NETWORK ANALYZERS USING A COMB GENERATOR

PROCÉDÉ ET DISPOSITIF D'ÉTALONNAGE D'ANALYSEURS DE RÉSEAU AVEC UN GÉNÉRATEUR DE FONCTIONS EN PEIGNE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **21.06.2007   DE 102007028725**

(43) Veröffentlichungstag der Anmeldung:
**24.02.2010   Patentblatt 2010/08**

(73) Patentinhaber: **Rohde & Schwarz GmbH & Co. KG 81671 München (DE)**

(72) Erfinder: **HEUERMANN, Holger 52223 Stolberg-Breinig (DE)**

(74) Vertreter: **Körfer, Thomas et al Mitscherlich PartmbB Patent- und Rechtsanwälte Sonnenstrasse 33 80331 München (DE)**

(56) Entgegenhaltungen:
**US-B1- 6 529 844**

- **BLOCKLEY P ET AL: "Mixer-based, vector-corrected, vector signal/network analyzer offering 300kHz-20 GHz bandwidth and traceable phase response" MICROWAVE SYMPOSIUM DIGEST, 2005 IEEE MTT-S INTERNATIONAL LONG BEACH, CA, USA 12-17 JUNE 2005, PISCATAWAY, NJ, USA,IEEE, 12. Juni 2005 (2005-06-12), Seiten 1497-1500, XP010844793 ISBN: 978-0-7803-8846-8**
- **BLOCKLEY P ET AL: "Wide-bandwidth, vector-corrected measurement with high spurious-free dynamic range" ARFTG CONFERENCE DIGEST, 2005. SPRING 2005. 65TH LONG BEACH, CA, USA 17 JUNE 2005, PISCATAWAY, NJ, USA,IEEE, US, 17. Juni 2005 (2005-06-17), Seiten 175-178, XP010830197 ISBN: 978-0-7803-8858-1**
- **DENIS BARATAUD ET AL: "Measurements of Time-Domain Voltage/Current Waveforms at RF and Microwave Frequencies Based on the Use of a Vector Network Analyzer for the Characterization of Nonlinear Devices-Application to High-Efficiency Power Amplifiers and Frequency-Multipliers Optimization" IEEE TRANSACTIONS ON INSTRUMENTATION AND MEASUREMENT, IEEE SERVICE CENTER, PISCATAWAY, NJ, US, Bd. 47, Nr. 5, 1. Oktober 1998 (1998-10-01), XP011024573 ISSN: 0018-9456**

- BLOCKLEY P S ET AL: "The Random Component of Mixer-Based Nonlinear Vector Network Analyzer Measurement Uncertainty" IEEE TRANSACTIONS ON MICROWAVE THEORY AND TECHNIQUES, IEEE SERVICE CENTER, PISCATAWAY, NJ, US, Bd. 55, Nr. 10, 1. Oktober 2007 (2007-10-01), Seiten 2231-2239, XP011193575 ISSN: 0018-9480
- JONATHAN BRERETON SCOTT ET AL: "Enhanced On-Wafer Time-Domain Waveform Measurement Through Removal of Interconnect Dispersion and Measurement Instrument Jitter" IEEE TRANSACTIONS ON MICROWAVE THEORY AND TECHNIQUES, IEEE SERVICE CENTER, PISCATAWAY, NJ, US, Bd. 50, Nr. 12, 1. Dezember 2002 (2002-12-01), Seiten 3022-3028, XP011076802 ISSN: 0018-9480
- SCOTT J B ET AL: "A new instrument architecture for millimetre-wave time-domain signal analysis" ARFTG 63RD CONFERENCE, SPRING 2004 FORT WORTH, TX JUNE 11, 2004, PISCATAWAY, NJ, USA,IEEE, 1. Januar 2004 (2004-01-01), Seiten 47-52, XP010764071 ISBN: 978-0-7803-8371-5
- VAN DEN BROECK T ET AL: "Calibrated vectorial nonlinear-network analyzers" MICROWAVE SYMPOSIUM DIGEST, 1994., IEEE MTT-S INTERNATIONAL SAN DIEGO, CA, USA 23-27 MAY 1994, NEW YORK, NY, USA,IEEE, 23. Mai 1994 (1994-05-23), Seiten 1069-1072, XP010586399 ISBN: 978-0-7803-1778-9
- WENDY VAN MOER ET AL: "A large-signal network analyzer: Why is it needed?" IEEE MICROWAVE MAGAZINE, IEEESERVICE CENTER, PISCATAWAY, NJ, US, Bd. 7, Nr. 6, 1. Januar 2006 (2006-01-01), Seiten 46-62, XP011143967 ISSN: 1527-3342

**EP 2 156 202 B1**

**Beschreibung**

Die Erfindung betrifft ein Verfahren und eine Vorrichtung zur Kalibrierung von vektoriellen Netzwerkanalysatoren zur Messung von linearen und nichtlinearen elektrischen Parametern, vorzugsweise ohne Durchverbindungen.

In der Präzisionselektronik dienen bei tiefen Frequenzen bis hin zur Mikrowellentechnik im GHz-Bereich vektorielle Netzwerkanalysatoren (VNA) der präzisen Vermessung von elektronischen Bauteilen und Komponenten von aktiven und passiven Schaltungen und Baugruppen.

Ein VNA nimmt die sogenannten Streuparameter von n-Toren (n=1,2, ...) auf, die ggf. in 2n-Pol-Parameter (z.B. Z- oder Y-Parameter) umgerechnet werden. Bei mittleren und hohen Frequenzen (schnellen Schaltungen) weisen diese aufgenommenen Daten jedoch sehr große Messfehler auf.

Eine sogenannte Systemfehlerkorrektur der VNA sorgt dafür, dass präzise Messungen schneller elektronischer Bauteile überhaupt durchführbar sind. Die Messgenauigkeit von VNA hängt in erster Linie von der Verfügbarkeit eines Verfahrens zur Systemfehlerkorrektur ab.

Bei der Systemfehlerkorrektur werden innerhalb des sog. Kalibriervorganges Messobjekte, die teilweise oder ganz bekannt sind, im Reflexions- und/oder Transmissionsverhalten vermessen.

Dies ist z.B. aus der DE 199 18 960 A1 bekannt.

Das Dokument Blockley P. et al.: "Mixer-Based, Vector-Corrected, Vector Signal/Network Analyzer Offering 300kHz-20GHz Bandwidth and Traceable Phase Response", MICROWAVE SYMPOSIUM DIGEST, 2005 IEEE MTT-S INTERNATIONAL LONG BEACH, CA, USA 12-17 JUNE 2005, PISCATAWAY, NJ, USA, IEEE, 12. Juni 2005 (2005-06-12), Seiten 1497-1500, ISBN: 978-0-7803-8846-8, zeigt einen hochgenauen Vektornetzwerkanalysator für sehr hohe Frequenzen.

Das Dokument Blockley P. et al.: "Wide-Bandwidth, Vector-Corrected Measurement with High Spurious-Free Dynamic Range", ARFTG CONFERENCE DIGEST, 2005. SPRING 2005. 65TH LONG BEACH, CA, USA 17 JUNE 2005, PISCATAWAY, NJ, USA, IEEE, US, 17. Juni 2005 (2005-06-17), Seiten 175-178, ISBN: 978-0-7803-8858-1, zeigt ebenfalls einen Vektornetzwerkanalysator für sehr hohe Frequenzen.

Das Dokument Denis Barataud et al.: "Measurement of Time-Domain Voltage/Current Waveforms at RF and Microwave Frequencies Based on the USE of a Vector Network Analyzer for the Characterization of Nonlinear Devices-Application to High-Efficiency Power Amplifiers and Frequency-Multipliers Optimization", IEEE TRANSACTIONS ON INSTRUMENTATION AND MEASUREMENT, IEEE SERVICE CENTER, PISCATAWAY, NJ, US, Bd. 47, Nr. 5, 1. Oktober 1998 (1998-10-01), ISSN: 0018-9456, zeigt ebenfalls einen Vektornetzwerkanalysator für Signale sehr hoher Frequenzen.

Das Dokument Scott J. B. et al.: "A New Instrument Architecture for Millimetre-Wave Time-Domain Signal Analysis", ARFTG 63RD CONFERENCE, SPRING 2004 FORT WORTH, TX JUNE 11, 2004, PISCATAWAY, NJ, USA, IEEE, 1. Januar 2004 (2004-01-01), Seiten 47-52, ISBN: 978-0-7803-8371-5, zeigt ein Oszilloskop für extrem hohe Frequenzen.

Aus diesen Messwerten erhält man über spezielle Rechenverfahren Korrekturdaten (sog. Fehlergrößen oder -koeffizienten). Mit diesen Korrekturdaten und einer entsprechenden Korrekturrechnung bekommt man für jedes beliebige Messobjekt Messwerte, die von Systemfehlern des VNA und der Zuleitungen (Verkopplungen = Übersprecher, Fehlanpassungen = Reflexionen) befreit sind.

Die in der Hochfrequenztechnik übliche Beschreibungsform des elektrischen Verhaltens von Komponenten und Schaltungen erfolgt über die Streuparameter (auch S-Parameter). Die Streuparameter verknüpfen nicht Ströme und Spannungen, sondern Wellengrößen miteinander.

Diese Darstellung ist den physikalischen Gegebenheiten der Hochfrequenztechnik besonders gut angepasst. Bei Bedarf können diese Streuparameter in andere elektrische Netzwerkparameter, die Ströme und Spannungen verknüpfen, umgerechnet werden.

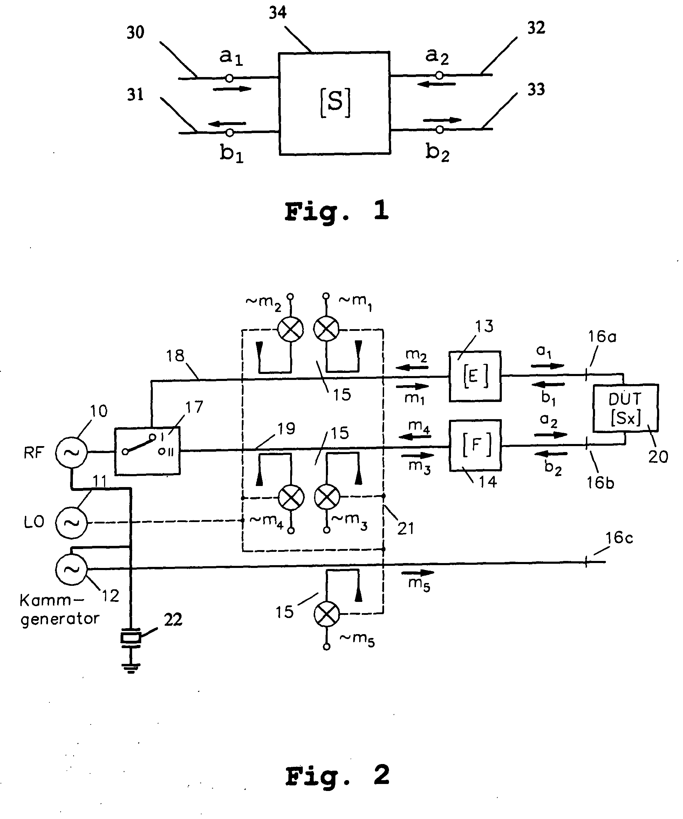

Fig. 1 zeigt ein Zweitor, das durch seine Streumatrix [S] gekennzeichnet sei. Die Wellen $a_1$ und $a_2$ seien die auf das Zweitor zulaufenden Wellen, $b_1$ und $b_2$ entsprechend die in umgekehrter Richtung sich fortpflanzenden Wellen. Es gilt die Beziehung:

$$\begin{pmatrix} b_1 \\ b_2 \end{pmatrix} = \begin{pmatrix} S_{11} & S_{12} \\ S_{21} & S_{22} \end{pmatrix} \begin{pmatrix} a_1 \\ a_2 \end{pmatrix}$$

Eine lineare Komponente ist durch diese S-Parameter, die über der Frequenz angegeben werden, ausreichend beschrieben. Bei einer Komponente, die nichtlineare Effekte aufweist, werden bei der Einspeisung eines Signals mit der Frequenz $f_0$ an einem Tor an der anderen Toren Signale mit dieser Grundfrequenz ($f_0$) und anderen Frequenzen erzeugt. Hierbei kann es sich z.B. um Oberwelle mit den Frequenzen $m*f_0$ (m = 2, 3, 4, ...) oder beim Ersatz mehrerer Sendegeneratoren um Intermodulations- oder Mischprodukte handeln. Moduliert man einen der Sendegeneratoren, so ist die Anzahl der Frequenzen entsprechend groß. Auch für diese nichtlinearen Komponenten können weiter die oben beschriebenen Streuparameter zur Beschreibung des Übertragungsverhaltens vorteilhaft verwendet werden. Jedoch gilt es nun zu berücksichtigen, dass man nicht nur die Tore, sondern auch die Frequenzen mit angibt.

So kann man zum Beispiel die vektorielle Streuparametergröße $S_{21}{}^{10}$ als Transmissionsübertragungsparameter mit dem Eingang Tor 1 bei der Grundwelle mit der Frequenz $f_0$ und dem Ausgang Tor 2 bei der Oberwelle mit der Frequenz $f_1 = 2 \cdot f_0$ einführen.

Bei vielen Anwendungen misst man jedoch diese nichtlinearen Übertragungeigenschaften von Bauelementen und Komponenten nicht mit einem vektoriellen Messgerät, da keine preiswerten Geräte zur Verfügung stehen. Die vektoriellen Aussagen sind jedoch für die Modellierung von Bauelementen wie Transistoren äußerst wichtig.

Stand der Technik sind für diese Messungen rein skalare Aufbauten. Moderne vektorielle Netzwerkanalysatoren besitzen Software-Optionen, die organisatorisch die Messungen von Oberwellen, Intermodulationen, Mischprodukten und ähnlichen zulassen. Aber diese werden nur rein skalar und somit ohne Systemfehlerkorrektur durchgeführt.

Bei der Messung von linearen Mehrtoren werden Kalibrierverfahren eingesetzt, die eine große Anzahl an Durchverbindungen erfordern. Ein häufig eingesetztes Verfahren zur Durchführung von Mehrtormessungen basiert auf dem 10-Term-Verfahren gemäß DE 199 18 697 A1. Diese benötigen die Verbindung aller Messtore. D.h., dass bei einem 8-Tor bereits 28 Durchverbindungen notwendig sind (berechnet sich aus: n/2*(n-1)). 8-Tor-Netzwerkanalysatoren sind bereits üblich. Für diese Geräte stellen die Hersteller oft automatische Kalibriereinheiten zur Verfügung. Jedoch ist der interne Aufwand für diese Anwendungen sehr groß.

Der Anwender von moderner Messtechnik möchte vektorielle Streuparameter nicht nur bei der Grundfrequenz sondern auch frequenzumsetzend mit einem vertretbaren Kostenaufwand messen können. Dieser Kostenaufwand sollte nur geringfügig über den Kosten von jetzigen Streuparametermessungen liegen.

Der Erfindung liegt die Aufgabe zu Grunde, ein Verfahren und eine Vorrichtung zur Kalibrierung vektorieller Netzwerkanalysatoren zu schaffen, welches bzw. welche auch für große Messtoranzahlen mit geringem Kostenaufwand automatisierbar ist und sich für die Kalibrierung zur Messung von linearen wie auch von nichtlinearen Parametern eignet. Eine Vermessbarkeit frequenzumsetzender Bauelemente ist dabei wünschenswert.

Die Aufgabe wird erfindungsgemäß für das Verfahren durch die Merkmale des unabhängigen Anspruchs 1 und durch die Merkmale des unabhängigen Anspruchs 10 für die Vorrichtung gelöst. Vorteilhafte Weiterbildungen sind Gegenstand der hierauf rückbezogenen Unteransprüche.

Zur Kalibrierung vektorieller Netzwerkkatalysatoren, welche über n Messtore verfügen, werden mehrere Kalibriermessungen durchgeführt. Dabei werden mehrere unterschiedliche Kalibrierstandards an die Messtore angeschlossen. Zur Kalibrierung wird eine Reihe von Messungen durchgeführt:

Zunächst wird in n Kalibriermessungen, ein Kammgeneratorsignal über eine direkte Verbindung nacheinander allen n Messtoren zugeführt. Mittels einer Messstelle am Ausgang des Kammgenerators und die, dem jeweiligen Messtor zugehörige Messstelle werden Phasenmessungen an sämtlichen das Kammgeneratorsignal bildenden Frequenzen durchgeführt. Aus den Phasenmessungen wird ein frequenzabhängiger Phasenversatz bestimmt. Weiterhin werden bei mindestens einer, vorzugsweise aber drei Messungen alle n Messtore nacheinander mittels jeweils bekannter, innerhalb einer Messung identischer Eingangsimpedanzen beliebiger Transmissionseigenschaften abgeschlossen, wobei nacheinander alle n Messtore mittels eines Sendeoszillators nacheinander mit sämtlichen Frequenzen des Kammgeneratorsignals angeregt werden. Die Eingangsimpedanzen der unterschiedlichen Messungen unterscheiden sich dabei deutlich. Durch die geschilderte Messabfolge kann der Netzwerkanalysator ohne die Notwendigkeit von Durchverbindungen kalibriert werden. Außerdem ist eine phasensynchrone, frequenzumsetzende Messung nach dieser Kalibrierung möglich.

Ein vorteilhafterweise bekannter und langzeitstabiler Frequenzverlauf der Leistung des Kammgenerators erlaubt ohne weitere Messungen eine eindeutige Charakterisierung der Fehlernetzwerke.

Alternativ können in einer nicht zu Erfindung gehörenden Ausgestaltung, in n weiteren Kalibriermessungen, vorteilhafterweise alle n Messtore nacheinander mit einem Leistungsmesser verbunden werden. Bei nicht bekanntem und/oder nicht langzeitstabilem Frequenzverlauf der Leistung des Kammgenerators ist durch diese zusätzlichen Messungen eine vollständige Kalibrierung möglich.

Vorteilhafterweise werden während der Messungen die Reflexionsparameter und Transmissionsparameter an sämtlichen mit den Messtoren verbundenen Anschlüssen des vektoriellen Netzwerkanalysators gemessen. Aus den so gemessenen Parametern, und dem Phasenversatz werden vorteilhafterweise Fehlernetzwerke berechnet, die zur Korrekturrechnung von Roh-Messwerten genutzt werden. Damit stehen alle für die Korrekturrechnung benötigten Parameter zur Verfügung.

Vorteilhafterweise werden zusätzlich die Leistungen der aus den Messtoren herauslaufenden Wellen zur Berechnung der Fehlernetzwerke berücksichtigt. Im Fall von nicht bekanntem Frequenzverlauf der Leistung des Kammgeneratorsignals oder mangelnder Langzeitstabilität kann so eine vollständige Charakterisierung der Fehlernetzwerke erreicht werden.

Der zumindest eine Sendeoszillator ist vorteilhafterweise an einen Referenzquarzoszillator angebunden. Der Kammgenerator ist ebenfalls vorteilhafterweise an den Referenzquarzoszillator angebunden. Durch die Verbindung des Kammgenerators und des Sendeoszillators mit demselben Referenzquarzoszillator ist eine phasensynchrone Messung möglich.

Die Kalibrierstandards und/oder der Kammgenerator und/oder der Leistungsmesser werden vorteilhafterweise unter Verwendung einer Auto-Kalibriereinheit und eines Umschalters elektronisch gesteuert angeschlossen. Damit ist eine schnelle Kalibrierung ohne Personalaufwand auch bei großen Messtoranzahlen möglich.

Die Erfindung erlaubt unter zusätzlichem Einsatz von nur einem Kammgenerator und einem Leistungsmesser aus einem VNA einen nichtlinearen VNA zu fertigen. Somit ist es möglich, ohne viel Mehraufwand gegenüber dem Stand der Technik zur Messung von linearen Komponenten einen VNA zur Messung von nichtlinearen VNA zu fertigen.

Automatische Kalibriereinheiten bestehen für das zugehörige Kalibrierverfahren aus lediglich drei Eintorstandards, und einem Leistungsmesser, über den die Hersteller von VNA verfügen. Somit vereinfacht sich die Kalibriereinheit gegenüber der bekannten von Multiport-VNA um Größenordnungen. Selbst Anwendungen mit 15 und mehr Toren können einfach kalibriert werden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:

Fig. 1    ein beispielhaftes Schaltbild eines Zweitors mit vier Anschlüssen;

Fig. 2    ein Schaltbild einer beispielhaften Ausgestaltung der erfindungsgemäßen Kalibriereinrichtung;

Fig. 3    eine erste beispielhafte Abfolge von Kalibriermessungen mit einem Wellenabschluss als Kalibrierstandard an den Messtoren eines vektoriellen Netzwerkanalysators;

Fig. 4    eine zweite beispielhafte Abfolge von Kalibriermessungen mit einem Kurzschluss als Kalibrierstandard an den Messtoren eines vektoriellen Netzwerkanalysators;

Fig. 5    eine dritte beispielhafte Abfolge von Kalibriermessungen mit einem Leerlauf als Kalibrierstandard an den Messtoren eines vektoriellen Netzwerkanalysators;

Fig. 6    eine vierte beispielhafte Abfolge von Kalibriermessungen bei Messung der Leistung an den Messtoren eines vektoriellen Netzwerkanalysators und

Fig. 7    eine fünfte beispielhafte Abfolge von Kalibriermessungen an den Messtoren eines vektoriellen Netzwerkanalysators bei Messung der Transmission mittels eines Kammgenerators.

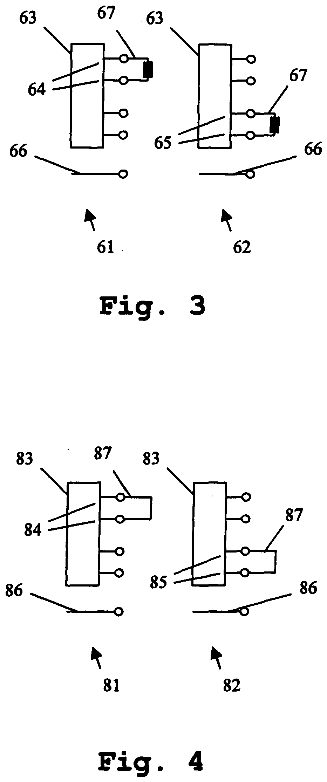

Zunächst wird anhand der Fig. 1 - 2 der Aufbau und die erfindungsgemäße Verschaltung des zu kalibrierenden Netzwerkanalysators erläutert. Mittels Fig. 3 - 7 wird das erfindungsgemäße Kalibrierverfahren in der Abfolge der Messanordnungen gezeigt. Identische Elemente wurden in ähnlichen Abbildungen zum Teil nicht wiederholt dargestellt und beschrieben.

Fig. 1 zeigt ein Zweitor, das durch seine Streumatrix [S] gekennzeichnet sei. Die Wellen $a_1$ und $a_2$ seien die auf das Zweitor zulaufenden Wellen, $b_1$ und $b_2$ entsprechend die in umgekehrter Richtung sich fortpflanzenden Wellen. Es gilt die Beziehung:

$$\begin{pmatrix} b_1 \\ b_2 \end{pmatrix} = \begin{pmatrix} S_{11} & S_{12} \\ S_{21} & S_{22} \end{pmatrix} \begin{pmatrix} a_1 \\ a_2 \end{pmatrix}$$

In Fig. 2 ist der in der Praxis interessante Fall eines 2-Tor Netzwerkanalysesystems nach dem so genannten Reflektometer-Konzept als Blockschaltbild illustriert. Man erkennt, dass 2n+1 Messstellen 15 zur Vermessung eines n-Tores notwendig sind. Fig. 2 zeigt auf, wie ein derartiger Aufbau zu realisieren ist und dient als Grundlage für die Beschreibung des Kalibrierverfahrens.

Der Netzwerkanalysator könnte auch nach dem so genannten GSOLT-Konzept aufgebaut sein und benötigte dann nur n+2 Messstellen zur Vermessung eines n-Tores. In diesem Fall befindet sich eine Messstelle direkt hinter dem RF-Oszillator 10 und die Messstellen $\sim m_2$ und $\sim m_4$ entfallen. Bei dieser Architektur ist der Schalter nun Teil der Fehlernetzwerke und muss eine Langzeitstabilität aufweisen. Bei dem Konzept nach Fig. 2 kann der Schalter 17 dadurch ersetzt werden, dass man zwei (oder im Mehrtorfall n) RF-Quellen einsetzt und bei Bedarf aktiviert. Eine Mehrtoranordnung ergibt sich indem man den Schalter 17 weitere Ausgänge zufügt und die Messkanäle mit den Messstellen 15 ergänzt. Im Folgenden wird anhand von Fig. 2 nur ein Zweitor-VNA betrachtet. Diese Betrachtung kann jedoch einfach auf ein Mehrtor-Gerät erweitert werden.

In Fig. 2 wird dargestellt, wie das Hochfrequenzsignal der RF-Quelle 10 über einen Umschalter 17, dessen Eigenschaften Reproduzierbarkeit, Reflexion, Langzeitstabilität usw. nicht in die Messgenauigkeit aber in eine mögliche Arbeitspunktverschiebung eingehen, auf die zwei Zweige 18 oder 19 geleitet wird. Die linear umsetzenden Messstellen 15 nehmen jeweils ein Maß für die hinlaufende, reflektierte oder transmittierte Welle auf. Die Signale der Messstellen werden bevorzugt parallel abgerufen, können aber auch seriell abgerufen werden, da dieses Messsystem einschließlich der Schalter und Oszillatoren kurzzeitstabil ist. Die Messstellen sind durch einem Koppler und einem Mischer illustriert. Zur Frequenzumsetzung des RF-Signales in einen niederfrequenten Zwischenfrequenzbereich (IF-Signal) wird ein zweiter Generator benötigt. Hierbei handelt es sich um den LO-Generator 11, der über in Fig. 2 nicht enthaltene Signalteiler und die Leitungen 21 die Mischer speist. Um zeitlich gleiche frequenzumsetzende Messungen durchzuführen, kann man auch mehrere LO-Oszillatoren einsetzen. Sämtliche deterministischen Nichtidealitäten und Unvollkommenheiten des VNAs zwischen Umschaltern und Messtorebenen in Form von Fehlanpassungen und Übersprechern werden in den Fehlermatrizen 13 und 14 zusammengefasst und berücksichtigt. An den Messtoren 16a und 16b ist das Messobjekt 20 (DUT: Device Under Test) mit dem vektoriellen Zweitor-Netzwerkanalysator verbunden.

Im Gegensatz zu einem VNA für lineare Messungen wird nun noch ein Kammgenerator 12 benötigt. Dessen Ausgangssignal wird einerseits von der Messstelle $\sim m_5$ detektiert und steht andererseits als Kalibriersignal am Messtorausgang 16c zur Verfügung. Alle drei Generatoren 10, 11 und 12 sind vorzugsweise an einem Referenzquarzoszillator 22 angebunden. Somit stehen die Oberwellen des Kammgenerators in einem festen Phasenverhältnis zur Grundschwingung des Referenzquarzoszillators 22.

Das Kalibrierverfahren dieser Erfindung soll im Weiteren als das WT-Verfahren (WT: Without Thru) bezeichnet werden. Dieses Verfahren lässt sich von der mathematischen Seite in zwei Schritte unterteilen:

> 1.: Direkte Kalibrierung und
> 2.: Systemfehlerkorrektur.

**Beim ersten Schritt "Direkte Kalibrierung"** werden zunächst die Kalibrierstandards vermessen, dann die Leistungen an den Messtoren mittels eines Leistungsmessers bestimmt, im Weiteren die Phase des Kammgeneratorsignals vermessen und abschließend die Fehlerkoeffizienten berechnet. Hierzu müssen sämtliche elektrischen Eigenschaften der Kalibrierstandards bekannt sein (z.B. in Form der Streuparameter). Bei diesem Kalibrierverfahren werden nur so genannte Absolutstandards eingesetzt. Bei den **Absolutstandards** handelt es sich um physikalische Bauteile, deren elektrisches Verhalten aus einer Präzisionsfertigung und Berechnung bekannt sind. Für das WT-Verfahren werden i.d.R. die drei Absolutstandards eingesetzt:

> 1.: Der Impedanzstandard Match (Anpassung; M) muss vollständig bekannt sein, kann beim WT-Verfahren jedoch unterschiedlich zur Referenzimpedanz (i. d. R. 50Ω) sein. Derartige Standards werden oft auch als Transfer-Match bezeichnet.
> 2., 3.: Die Reflexionsstandards Short (Kurzschluss; S) und Open (Leerlauf; O) müssen vollständig bekannt sein, brauchen beim WT-Verfahren jedoch nicht die idealen Werte eines Kurzschlusses oder eines Leerlaufes einhalten. Derartige Standards werden oft auch als Transfer-Reflect bezeichnet. Die Absolutstandards S und O sind vom Hersteller präzise beschrieben und diese Werte werden direkt eingesetzt.

Die Standards M, S und O können auch durch drei andere bekannte Reflexionsstandards wie drei Offset-Shorts ersetzt werden.

Gemäß den Ansprüchen werden beim WT-Verfahren für die Kalibrierung an jedem Messtor (hier 16a und 16b) die drei Eintorstandards M, S und O kontaktiert und vermessen. Danach wird an jedem Messtor (hier 16a und 16b) mittels eines Leistungsmessers die Leistung der herauslaufende Welle detektiert. Als letztes wird das Kammgeneratorsignal des Ausganges 16c mit jedem Messtor (hier 16a und 16b) verbunden und die zugehörige Transmissionsphase detektiert.

Aus diesen Daten werden für jedes Reflektometer (hier 13 und 14) die vier **absoluten** Fehlerkoeffizienten berechnet. D.h., es findet eine n-fache Eintorkalibrierung statt. Da die Fehlernetzwerke absolut bekannt sind, wird keine Durchverbindung oder sonstige Transmissionsinformation mehr benötigt. Für den VNA nach Fig. 2 werden somit 8 Fehlerterme bestimmt. Die zugehörige Mathematik für eine Eintorkalibrierung basiert auf den mathematischen Resultaten in P. Blockley, D. Gunyan, and J. B. Scott, "Mixer-based, vector-corrected, vector signal/network analyzer offering 300kHz-20GHz," IEEE MTT-S, Juni 2005 bzw. den dort zitierten Schriften. Die Berechnung der Fehlerkoeffizienten $E_D$,

$E_S$ und $E_{FR}$ des 3-Term-verfahrens ist aus der Literatur hinreichend bekannt. Mittels der Kammgeneratormessung und der Leistungsmessung kann nunmehr ER berechnet werden.

Die Formeln zur Berechnung des Betrags und der Phase des Fehlerkoeffizienten ER lauten wie folgt:

$$\left|E_R\right|^2 = \frac{\left|E_S \cdot b_{1m} - a_{1m} \cdot \Delta X\right|^2 \cdot \left(1 - \left|\Gamma_C\right|^2\right)}{P_{meter1}}$$

$$\angle(E_R) = \angle \quad \left(\frac{b_{1m} - b_{1m} \cdot E_S \cdot \Gamma_R - E_D \cdot a_{1m} + \Delta X \cdot a_{1m} \cdot \Gamma_R}{a_R}\right)$$

$\Gamma_C$ : Reflexionsfaktor des Leistungsmessers
$\Gamma_R$ : Reflexionsfaktor der Phasenreferenz
$a_R$: In die Phasenreferenz einfallende Welle

mit

$$\Delta X = E_D \cdot E_S - E_{FR}$$

Bei den Wellengrößen $a_{1m}$ und $b_{1m}$ handelt es sich für Tor 1 um die Wellengrößen $m_1$ und $m_2$. Da nunmehr $E_R$ und $E_{FR}$ bekannt sind, kann $E_F$ berechnet werden: $E_F = E_{FR} / E_R$.

**Beim zweiten Schritt "Systemfehlerkorrektur"** werden die Messdaten eines unbekannten Messobjektes von den Fehlern des VNAs und den Zuleitungen korrigiert. Zur Herleitung einer mathematischen Lösung für dieses Problem gibt es aus heutiger Sicht viele interessante Ansätze. Der Erfinder hat für Zweitoranordnungen ein großes Spektrum an mathematischen Lösungen und auch für Mehrtorlösungen einfach zu programmierende Alternativen zu den bekannten Lösungen erarbeitet und publiziert. Alle Lösungen aus der Theorie der linearen VNA-Messungen können adaptiert werden.

Beispielsweise lassen sich die als S-Parameter definierten Fehlerkoeffizienten der Matrizen [E] und [F] in die Fehlermatrizen [A] und [B₁], die auf Transmissionskoeffizienten beruhen, umrechnen. Dieser Ansatz lässt sich auch direkt in das Multiportproblem mit den Fehlermatrizen [A] und [B$_i$] mit i = 1, 2, ..., n-1 erweitern. Die Ausgangsbasis für die mathematische Beschreibung bildet das Fehlermodell in Fig. 2. Im Weiteren ist es vorteilhaft, die mathematische Formulierung der Fehlerzweitore in der inversen Form der angegebenen Transmissionsparameter anzusetzen:

$$[G] = [A]^{-1} \quad , \quad [H_i] = [B_i]^{-1} \quad , \quad i = 1, 2, ..., n-1 \quad (2)$$

wobei für die Ein- und Ausgänge an den Fehlernetzwerken

$$\begin{pmatrix} b_1 \\ a_1 \end{pmatrix} = [G] * \begin{pmatrix} m_1 \\ m_2 \end{pmatrix} \quad , \quad \begin{pmatrix} a_i \\ b_i \end{pmatrix} = [H_i] * \begin{pmatrix} m_{2i-1} \\ m_{2i} \end{pmatrix} \quad (3)$$

gilt. Diese Gleichungen lassen sich nach den Wellengrößen $a_i$ und $b_i$ auflösen und für ein Viertor in die Gleichung

$$\begin{pmatrix} b_1 \\ b_2 \\ b_3 \\ b_4 \end{pmatrix} = \begin{bmatrix} & Sx & \end{bmatrix} \begin{pmatrix} a_1 \\ a_2 \\ a_3 \\ a_4 \end{pmatrix} \quad (4)$$

einsetzen. Hierbei bekommt man für jede Schalterstellung die Werte einer Matrixspalte, was letztlich zu einem linearen Gleichungssystem, bestehend aus zwei n*n Messwertmatrizen und der n*n Streumatrix, führt. Löst man dieses Gleichungssystem nach der [Sx]-Matrix auf, so stehen einem die fehlerkorrigierten Streuparameter eines n-Tores zur Verfügung.

Zwei oder mehr Messtore, die einem VNA zugeordnet werden, müssen sich nicht in unmittelbarer räumlicher Nähe befinden, da eine Durchverbindung bei diesem Kalibrierverfahren erstmalig nicht mehr notwendig ist. Folglich kann man Übertragungsstrecken, die in großer Entfernung stehen, präzise vermessen. Somit können Analysen von Luft und Atmosphäre durchgeführt werden. Der Mikrowellen-Analytik steht ein ganz neues Messmittel zur Verfügung. Auch Antennen lassen sich über große Entfernungen und somit unter Fernfeldbedingungen vorteilhaft vermessen. Über präzise Phasenmessungen von Freiraumübertragungs-strecken kann somit eine Vielzahl von Umwelteinflüssen analysiert werden.

Fig. 3 zeigt eine erste beispielhafte Abfolge von Kalibriermessungen mit einem Wellenabschluss als Kalibrierstandard an den Messtoren eines vektoriellen Netzwerkanalysators. Die verschiedenen Darstellungen des Netzwerkanalysators 61 - 62 zeigen aufeinander folgende Schritte der Kalibriermessung. Der erste Schritt 61 einer Kalibriermessung an dem Netzwerkanalysator 63 ist hier verdeutlicht. An dem ersten Tor 64 des Netzwerkanalysators 63 ist eine Impedanz 67 als Abschluss angeschlossen. Der Kammgenerator 66 ist nicht verbunden. Der zweite Schritt 62 einer Kalibriermessung ist weiterhin verdeutlicht. An dem zweiten Tor 65 des Netzwerkanalysators 63 ist eine Impedanz 67 als Abschluss angeschlossen. Der Kammgenerator 66 ist nicht verbunden.

In Fig. 4 wird eine zweite beispielhafte Abfolge von Kalibriermessungen mit einem Kurzschluss als Kalibrierstandard an den Messtoren eines vektoriellen Netzwerkanalysators gezeigt. Die verschiedenen Darstellungen des Netzwerkanalysators 81 - 82 zeigen aufeinander folgende Schritte der Kalibriermessung. Der erste Schritt 81 einer Kalibriermessung an dem Netzwerkanalysator 83 ist hier verdeutlicht. An dem ersten Tor 84 des Netzwerkanalysators 83 ist ein Kurzschluss 87 als Abschluss angeschlossen. Der Kammgenerator 86 ist nicht verbunden. Der zweite Schritt 82 einer Kalibriermessung ist weiterhin verdeutlicht. An dem zweiten Tor 85 des Netzwerkanalysators 83 ist ein Kurzschluss 87 als Abschluss angeschlossen. Der Kammgenerator 86 ist nicht verbunden.

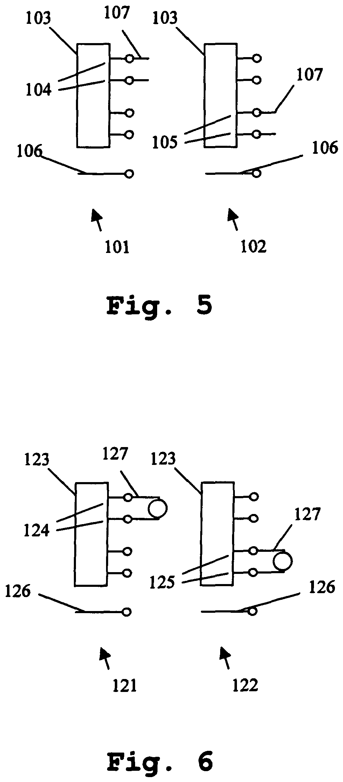

Fig. 5 zeigt eine dritte beispielhafte Abfolge von Kalibriermessungen mit einem Leerlauf als Kalibrierstandard an den Messtoren eines vektoriellen Netzwerkanalysators. Die verschiedenen Darstellungen des Netzwerkanalysators 101 - 102 zeigen aufeinander folgende Schritte der Kalibriermessung. Der erste Schritt 101 einer Kalibriermessung an dem Netzwerkanalysator 103 ist hier verdeutlicht. An dem ersten Tor 104 des Netzwerkanalysators 103 ist ein Leerlauf 107 als Abschluss angeschlossen. Der Kammgenerator 106 ist nicht verbunden. Der zweite Schritt 102 einer Kalibriermessung ist weiterhin verdeutlicht. An dem zweiten Tor 105 des Netzwerkanalysators 103 ist ein Leerlauf 107 als Abschluss angeschlossen. Der Kammgenerator 106 ist nicht verbunden.

In Fig. 6 wird eine vierte beispielhafte Abfolge von Kalibriermessungen bei Messung der Leistung an den Messtoren eines vektoriellen Netzwerkanalysators gezeigt. Die verschiedenen Darstellungen des Netzwerkanalysators 121 - 122 zeigen aufeinander folgende Schritte der Kalibriermessung. Der erste Schritt 121 einer Kalibriermessung an dem Netzwerkanalysator 123 ist hier verdeutlicht. An dem ersten Tor 124 des Netzwerkanalysators 123 ist ein Leistungsmesser 127 angeschlossen. Der Kammgenerator 126 ist nicht verbunden. Der zweite Schritt 122 einer Kalibriermessung ist weiterhin verdeutlicht. An dem zweiten Tor 125 des Netzwerkanalysators 123 ist ein Leistungsmesser 127 angeschlossen. Der Kammgenerator 126 ist nicht verbunden. Der Leistungsmesser 127 misst die aus dem jeweiligen Messtor 124, 125 herauslaufende Leistung.

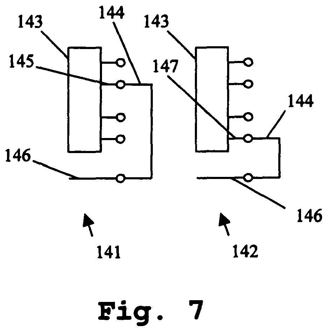

Fig. 7 zeigt eine fünfte beispielhafte Abfolge von Kalibriermessungen an den Messtoren eines vektoriellen Netzwerkanalysators bei Messung der Transmission mittels eines Kammgenerators. Die verschiedenen Darstellungen des Netzwerkanalysators 141 - 142 zeigen aufeinander folgende Schritte der Kalibriermessung. Der erste Schritt 141 einer Kalibriermessung an dem Netzwerkanalysator 143 ist hier verdeutlicht. Ein erster Anschluss 145 eines ersten Messtors des Netzwerkanalysators 143 ist mittels einer Verbindungsleitung 144 mit dem Kammgenerator 141 verbunden. Der zweite Schritt 142 einer Kalibriermessung ist weiterhin verdeutlicht. Ein zweiter Anschluss 147 eines ersten Messtors des Netzwerkanalysators 143 ist mittels einer Verbindungsleitung 144 mit dem Kammgenerator 141 verbunden. Während dieser Messung ist der Sendeoszillator 10 abgeschaltet. Das Kammgeneratorsignal wird an dem jeweiligen Anschluss 145, 147 eingespeist und an der zum dem jeweiligen Anschluss gehörenden Messstelle gemessen. Dabei wird die Phase des Signals ermittelt.

Die Erfindung ist nicht auf das dargestellte Ausführungsbeispiel beschränkt. Wie bereits erwähnt, können unterschiedliche Kalibrierstandards eingesetzt werden. Ebenfalls ist der Einsatz bei beliebiger Anzahl an Messtoren möglich. Alle vorstehend beschriebenen Merkmale oder in den Figuren gezeigten Merkmale sind im Rahmen der Erfindung beliebig miteinander kombinierbar.

**Patentansprüche**

1. Verfahren zum Kalibrieren vektorieller Netzwerkanalysatoren, welche über n Messtore (16a, 16b) verfügen, wobei mehrere Kalibriermessungen durchgeführt werden, wobei mehrere unterschiedliche Kalibrierstandards (67, 87, 107, 146) an die Messtore (16a, 16b) angeschlossen werden, wobei n eine beliebige natürliche Zahl ist, wobei zur Kalibrierung die folgenden Messungen durchgeführt werden:

   - n Kalibriermessungen,
   wobei ein Kammgeneratorsignal mittels einer Verbindungsleitung nacheinander allen n Messtoren (16a, 16b) zugeführt wird,
   wobei das Kammgeneratorsignal eine Summe mehrerer sinusförmiger Signale äquidistanten Frequenzabstands ist, **dadurch gekennzeichnet, dass** nacheinander die Phase der einzelnen Signale des Kammgeneratorsignals gleichzeitig an einer Messstelle am Kammgenerator ($m_5$) und an einer Messstelle des jeweiligen Messtors gemessen wird,
   wobei aus den gemessenen Phasen ein frequenzabhängiger Phasenversatz der einzelnen Signale ermittelt wird,
   - eine Kalibriermessung,
   wobei alle n Messtore (16a, 16b) mittels jeweils bekannter identischer erster Eingangsimpedanzen (67) beliebiger Transmissionseigenschaften abgeschlossen werden,
   wobei nacheinander alle n Messtore mittels eines Sendeoszillators nacheinander mit sämtlichen Frequenzen des Kammgeneratorsignals angeregt werden.

2. Verfahren nach Anspruch 1,
   **gekennzeichnet durch,**

   - eine weitere Kalibriermessung,
   wobei alle n Messtore (16a, 16b) mittels jeweils bekannter identischer zweiter Eingangsimpedanzen (87) beliebiger Transmissionseigenschaften, die sich von den ersten Eingangsimpedanzen unterscheiden, abgeschlossen werden,
   wobei nacheinander alle n Messtore mittels eines Sendeoszillators nacheinander mit sämtlichen Frequenzen des Kammgeneratorsignals angeregt werden, und
   - eine weitere Kalibriermessung,
   wobei alle n Messtore (16a, 16b) mittels jeweils bekannter identischer dritter Eingangsimpedanzen (107) beliebiger Transmissionseigenschaften, die sich von den ersten und zweiten Eingangsimpedanzen unterscheiden, abgeschlossen werden,
   wobei nacheinander alle n Messtore mittels eines Sendeoszillators nacheinander mit sämtlichen Frequenzen des Kammgeneratorsignals angeregt werden.

3. Verfahren nach Anspruch 1 oder 2,
   **dadurch gekennzeichnet,**
   **dass** der Frequenzverlauf der Leistung des Kammgeneratorsignals bekannt und langzeitstabil ist.

4. Verfahren nach Anspruch 1 oder 2,
   **dadurch gekennzeichnet,**
   **dass** der Frequenzverlauf der Leistung des Kammgeneratorsignals nicht bekannt und/oder nicht langzeitstabil ist, und
   **dass** die folgenden zusätzlichen Messungen durchgeführt werden:

   - n Kalibriermessungen,
   wobei alle n Messtore (16a, 16b) nacheinander mit einem Leistungsmesser (127) verbunden werden, wobei die Leistung der aus dem Messtor (16a, 16b) herauslaufenden Welle gemessen wird,
   wobei nacheinander alle n Messtore mittels eines Sendeoszillators nacheinander mit sämtlichen Frequenzen des Kammgeneratorsignals angeregt werden.

5. Verfahren nach einem der Ansprüche 1 bis 4,
   **dadurch gekennzeichnet,**
   **dass** Reflexionsparameter und Transmissionsparameter an sämtlichen mit den Messtoren (16a, 16b) verbundenen Anschlüssen (18, 19) des vektoriellen Netzwerkanalysators gemessen werden,
   **dass** aus den gemessenen Reflexionsparametern, Transmissionsparametern und dem Phasenversatz Fehlernetzwerke (13, 14) berechnet werden,
**dass** die Fehlernetzwerke (13, 14) durch Matrizen dargestellt werden, welche die für eine Korrekturrechnung von Roh-Messwerten notwendigen Daten enthalten.

6. Verfahren nach einem der Ansprüche 1 bis 4,
**dadurch gekennzeichnet,**
**dass** Reflexionsparameter und Transmissionsparameter an sämtlichen mit den Messtoren (16a, 16b) verbundenen Anschlüssen (18, 19) des vektoriellen Netzwerkanalysators gemessen werden,
**dass** aus gemessenen Reflexionsparametern, Transmissionsparametern, dem Phasenversatz und Leistungen der aus den Messtoren herauslaufenden Wellen Fehlernetzwerke (13, 14) berechnet werden,
**dass** die Fehlernetzwerke (13, 14) durch Matrizen dargestellt werden, welche die für eine Korrekturrechnung von Roh-Messwerten notwendigen Daten enthalten.

7. Verfahren nach einem der Ansprüche 1 bis 6,
**dadurch gekennzeichnet,**
**dass** der Sendeoszillator (10) an einen Referenzoszillator (22) gekoppelt ist,
**dass** der Kammgenerator (12, 146) an den gleichen Referenzoszillator (22) gekoppelt ist.

8. Verfahren nach einem der Ansprüche 1 bis 7,
**dadurch gekennzeichnet,**
**dass** die Kalibrierstandards (67, 87, 107) und/oder der Kammgenerator (12, 146) durch eine Auto-Kalibriereinheit unter Verwendung eines Umschalters elektronisch gesteuert angeschlossen werden.

9. Verfahren nach Anspruch 4,
**dadurch gekennzeichnet,**
**dass** ein Leistungsmesser (127) durch eine Auto-Kalibriereinheit unter Verwendung eines Umschalters elektronisch gesteuert angeschlossen wird.

10. Vorrichtung zum Kalibrieren vektorieller Netzwerkanalysatoren, welche über n Messtore (16a, 16b) verfügen, mit mehreren unterschiedlichen Kalibrierstandards (67, 87, 107, 146),
wobei die Vorrichtung mehrere Kalibriermessungen durchführt,
wobei die mehreren unterschiedlichen Kalibrierstandards (67, 87, 107, 146) an die Messtore (16a, 16b) angeschaltet werden,
wobei n eine beliebige natürliche Zahl ist, wobei die Vorrichtung zur Kalibrierung die folgenden Messungen durchführt:

- n Kalibriermessungen,
wobei ein Kammgeneratorsignal mittels einer Verbindungsleitung nacheinander allen n Messtoren (16a, 16b) zugeführt wird,
wobei das Kammgeneratorsignal eine Summe mehrerer sinusförmiger Signale äquidistanten Frequenzabstands ist, **dadurch gekennzeichnet,**
**dass** die Vorrichtung nacheinander die Phase der einzelnen Signale des Kammgeneratorsignals gleichzeitig an einer Messstelle am Kammgenerator ($m_5$) und an einer Messstelle des jeweiligen Messtors misst,
wobei die Vorrichtung aus den gemessenen Phasen einen frequenzabhängigen Phasenversatz ermittelt,
- eine Kalibriermessung,
wobei alle n Messtore (16a, 16b) mittels jeweils bekannter identischer erster Eingangsimpedanzen (67) beliebiger Transmissionseigenschaften abgeschlossen sind,
wobei die Vorrichtung nacheinander alle n Messtore mittels eines Sendeoszillators nacheinander mit sämtlichen Frequenzen des Kammgeneratorsignals angeregt.

11. Vorrichtung nach Anspruch 10,
**dadurch gekennzeichnet,**
**dass** die Vorrichtung folgende weitere Kalibriermessungen durchführt:

- eine Kalibriermessung,
wobei alle n Messtore (16a, 16b) mittels jeweils bekannter identischer zweiter Eingangsimpedanzen (87) beliebiger Transmissionseigenschaften, die sich von den ersten Eingangsimpedanzen unterscheiden, abgeschlossen sind,

wobei die Vorrichtung nacheinander alle n Messtore mittels eines Sendeoszillators nacheinander mit sämtlichen Frequenzen des Kammgeneratorsignals anregt sind, und

- eine Kalibriermessung,

wobei alle n Messtore (16a, 16b) mittels jeweils bekannter identischer dritter Eingangsimpedanzen (107) beliebiger Transmissionseigenschaften, die sich von den ersten und zweiten Eingangsimpedanzen unterscheiden, abgeschossen sind,

wobei die Vorrichtung nacheinander alle n Messtore mittels eines Sendeoszillators nacheinander mit sämtlichen Frequenzen des.Kammgeneratorsignals anregt.

12. Vorrichtung nach Anspruch 10 oder 11,
**dadurch gekennzeichnet,**
**dass** der Frequenzverlauf der Leistung des Kammgeneratorsignals bekannt und langzeitstabil ist.

13. Vorrichtung nach Anspruch 10 oder 11,
**dadurch gekennzeichnet,**
**dass** der Frequenzverlauf der Leistung des Kammgeneratorsignals nicht bekannt und/oder nicht langzeitstabil ist, und
**dass** die Vorrichtung die folgenden zusätzlichen Messungen durchführt:

- n Kalibriermessungen,

wobei die Vorrichtung alle n Messtore (16a, 16b) nacheinander mit einem Leistungsmesser (127) verbindet, wobei die Leistung der aus dem Messtor (16a, 16b) herauslaufenden Welle gemessen wird, wobei die Vorrichtung nacheinander alle n Messtore mittels eines Sendeoszillators nacheinander mit sämtlichen Frequenzen des Kammgeneratorsignals anregt.

14. Vorrichtung nach einem der Ansprüche 10 bis 13,
**dadurch gekennzeichnet,**
**dass** die Vorrichtung Reflexionsparameter und Transmissionsparameter an sämtlichen mit den Messtoren (16a, 16b) verbundenen Anschlüssen (18, 19) des vektoriellen Netzwerkanalysators misst,
**dass** die Vorrichtung eine Recheneinrichtung aufweist, die aus den gemessenen Reflexionsparametern, Transmissionsparametern und dem Phasenversatz Fehlernetzwerke (13, 14) berechnet,
wobei die Fehlernetzwerke (13, 14) durch Matrizen dargestellt werden, welche die für eine Korrekturrechnung von Roh-Messwerten notwendigen Daten enthalten.

15. Vorrichtung nach einem der Ansprüche 10 bis 13,
**dadurch gekennzeichnet,**
**dass** die Vorrichtung Reflexionsparameter und Transmissionsparameter an sämtlichen mit den Messtoren (16a, 16b) verbundenen Anschlüssen (18, 19) des vektoriellen Netzwerkanalysators misst,
**dass** die Vorrichtung eine Recheneinrichtung aufweist, die aus gemessenen Reflexionsparametern, Transmissionsparametern, dem Phasenversatz und aus Leistungen der aus den Messtoren herauslaufenden Wellen Fehlernetzwerke (13, 14) berechnet,
wobei die Fehlernetzwerke (13, 14) durch Matrizen dargestellt werden, welche die für eine Korrekturrechnung von Roh-Messwerten notwendigen Daten enthalten.

16. Vorrichtung nach einem der Ansprüche 10 bis 15,
**dadurch gekennzeichnet,**
**dass** der Sendeoszillator (10) an einen Referenzoszillator (22) gekoppelt ist, und
**dass** der Kammgenerator (12, 146) an den gleichen Referenzoszillator (22) gekoppelt ist.

17. Vorrichtung nach einem der Ansprüche 10 bis 16,
**dadurch gekennzeichnet,**
**dass** die Vorrichtung die Kalibrierstandards (67, 87, 107) und/oder der Kammgenerator (12, 146) durch eine Auto-Kalibriereinheit unter Verwendung eines Umschalters elektronisch gesteuert anschließt.

18. Vorrichtung nach einem der Ansprüche 10 bis 17,
**dadurch gekennzeichnet,**
**dass** die Vorrichtung einen Leistungsmesser (127) durch eine Auto-Kalibriereinheit unter Verwendung eines Umschalters elektronisch gesteuert anschließt.

**Claims**

1. Method for calibration of vectorial network analysers which have n measurement ports (16a, 16b), wherein a plurality of calibration measurements are carried out,

wherein a plurality of different calibration standards (67, 87, 107, 146) are connected to the measurement ports (16a, 16b),

wherein n is an arbitrary natural number,

wherein the following measurements are carried out for calibration:

- n calibration measurements,

wherein a comb generator signal is fed in succession to all the n measurement ports (16a, 16b) by means of a connecting line,

wherein the comb generator signal is a sum of a plurality of sinusoidal signals with equidistant frequency spacing, **characterised in that**

in succession the phase of the individual signals of the comb generator signal is measured simultaneously at a measurement point on the comb generator ($m_5$) and at a measurement point of the respective measurement port, wherein a frequency-dependent phase offset of the individual signals is determined from the measured phases,

- a calibration measurement,

wherein all the n measurement ports (16a, 16b) are terminated by means of in each case known identical first input impedances (67) of arbitrary transmission properties,

wherein in succession all the n measurement ports are excited with all the frequencies of the comb generator signal in succession by means of a transmitting oscillator.

2. Method according to claim 1,
**characterised by**

- a further calibration measurement,

wherein all the n measurement ports (16a, 16b) are terminated by means of in each case known identical second input impedances (87) of arbitrary transmission properties which differ from the first input impedances, wherein in succession all the n measurement ports are excited with all the frequencies of the comb generator signal in succession by means of a transmitting oscillator, and

- a further calibration measurement,

wherein all the n measurement ports (16a, 16b) are terminated by means of in each case known identical third input impedances (107) of arbitrary transmission properties which differ from the first and second input impedances,

wherein in succession all the n measurement ports are excited with all the frequencies of the comb generator signal in succession by means of a transmitting oscillator.

3. Method according to claim 1 or 2,
**characterised in that**
the frequency response characteristic of the power of the comb generator signal is known and stable in the long term.

4. Method according to claim 1 or 2,
**characterised in that**
the frequency response characteristic of the power of the comb generator signal is not known and/or not stable in the long term, and
**in that** the following additional measurements are carried out:

- n calibration measurements,

wherein all the n measurement ports (16a, 16b) are connected with a power meter (127) in succession, and wherein the power of the wave flowing out of the measurement port (16a, 16b) is measured,

wherein in succession all the n measurement ports are excited with all the frequencies of the comb generator signal in succession by means of a transmitting oscillator.

5. Method according to one of claims 1 to 4,
**characterised in that**
reflection parameters and transmission parameters are measured at all the terminals (18, 19) of the vectorial network analyser which are connected with the measurement ports (16a, 16b),

**in that** error networks (13, 14)are calculated from the measured reflection parameters, transmission parameters and the phase offset,

**in that** the error networks (13, 14) are illustrated by matrices which contain the data necessary for correction calculation of raw measurement values.

6. Method according to one of claims 1 to 4,

**characterised in that**

reflection parameters and transmission parameters are measured at all the terminals (18, 19) of the vectorial network analyser which are connected with the measurement ports (16a, 16b),

**in that** error networks (13, 14)are calculated from the measured reflection parameters, transmission parameters, the phase offset and the powers of the waves flowing out of the measurement ports,

**in that** the error networks (13, 14) are illustrated by matrices which contain the data necessary for correction calculation of raw measurement values.

7. Method according to one of claims 1 to 6,

**characterised in that**

the transmitting oscillator (120) is coupled to a reference oscillator (22),

**in that** the comb generator (12, 146) is coupled to the same reference oscillator (22).

8. Method according to one of claims 1 to 7,

**characterised in that**

the calibration standards (67, 87, 107) and/or the comb generator (12, 146) are connected controlled electronically by an auto-calibration unit using a changeover switch.

9. Method according to claim 4,

**characterised in that**

a power meter (127) is connected controlled electronically by an auto-calibration unit using a changeover switch.

10. Device for calibration of vectorial network analysers which have n measurement ports (16a, 16b), with a plurality of different calibration standards (67, 87, 107, 146),

wherein the device carries out a plurality of calibration measurements,

wherein the plurality of different calibration standards (67, 87, 107, 146) are connected to the measurement ports (16a, 16b),

wherein n is an arbitrary natural number,

wherein the device carries out the following measurements for calibration:

- n calibration measurements,

wherein a comb generator signal is fed in succession to all the n measurement ports (16a, 16b) by means of a connecting line,

wherein the comb generator signal is a sum of a plurality of sinusoidal signals with equidistant frequency spacing, **characterised in that**

in succession the device measures the phase of the individual signals of the comb generator signal simultaneously at a measurement point on the comb generator ($m_5$) and at a measurement point of the respective measurement port,

wherein the device determines a frequency-dependent phase offset from the measured phases,

- a calibration measurement,

wherein all the n measurement ports (16a, 16b) are terminated by means of in each case known identical first input impedances (67) of arbitrary transmission properties,

wherein in succession the device excites all the n measurement ports with all the frequencies of the comb generator signal in succession by means of a transmitting oscillator.

11. Device according to claim 10,

**characterised in that**

the device carries out the following further calibration measurements:

- a calibration measurement,

wherein all the n measurement ports (16a, 16b) are terminated by means of in each case known identical second input impedances (87) of arbitrary transmission properties which differ from the first input impedances, wherein in succession the device excites all the n measurement ports with all the frequencies of the comb generator signal in succession by means of a transmitting oscillator, and
- a calibration measurement,
wherein all the n measurement ports (16a, 16b) are terminated by means of in each case known identical third input impedances (107) of arbitrary transmission properties which differ from the first and second input impedances,
wherein in succession the device excites all the n measurement ports with all the frequencies of the comb generator signal in succession by means of a transmitting oscillator.

**12.** Device according to claim 10 or 11,
**characterised in that**
the frequency response characteristic of the power of the comb generator signal is known and stable in the long term.

**13.** Device according to claim 10 or 11,
**characterised in that**
the frequency response characteristic of the power of the comb generator signal is not known and/or not stable in the long term, and
**in that** the device carries out the following additional measurements:

- n calibration measurements,
wherein the device connects all the n measurement ports (16a, 16b) with a power meter (127) in succession, and wherein the power of the wave flowing out of the measurement port (16a, 16b) is measured,
wherein in succession the device excites all the n measurement ports with all the frequencies of the comb generator signal in succession by means of a transmitting oscillator.

**14.** Device according to one of claims 10 to 13,
**characterised in that**
the device measures reflection parameters and transmission parameters at all the terminals (18, 19) of the vectorial network analyser which are connected with the measurement ports (16a, 16b),
**in that** the device has a calculating unit which calculates error networks (13, 14) from the measured reflection parameters, transmission parameters and the phase offset,
wherein the error networks (13, 14) are illustrated by matrices which contain the data necessary for correction calculation of raw measurement values.

**15.** Device according to one of claims 10 to 13,
**characterised in that**
the device measures reflection parameters and transmission parameters at all the terminals (18, 19) of the vectorial network analyser which are connected with the measurement ports (16a, 16b),
**in that** the device has a calculating unit which calculates error networks (13, 14) from the measured reflection parameters, transmission parameters, the phase offset and from the powers of the waves flowing out of the measurement ports,
wherein the error networks (13, 14) are illustrated by matrices which contain the data necessary for correction calculation of raw measurement values.

**16.** Device according to one of claims 10 to 15,
**characterised in that**
the transmitting oscillator (10) is coupled to a reference oscillator (22), and
**in that** the comb generator (12, 146) is coupled to the same reference oscillator (22).

**17.** Device according to one of claims 10 to 16,
**characterised in that**
the device connects the calibration standards (67, 87, 107) and/or the comb generator (12, 146) controlled electronically by an auto-calibration unit using a changeover switch.

**18.** Device according to one of claims 10 to 17,
**characterised in that**
the device connects a power meter (127) controlled electronically by an auto-calibration unit using a changeover switch.

**Revendications**

1. Procédé d'étalonnage d'analyseurs de réseau vectoriels, lesquels disposent de n portes de mesure (16a, 16b), dans lequel plusieurs mesures d'étalonnage sont mises en oeuvre, dans lequel plusieurs étalons (67, 87, 107, 146) différents sont connectés aux portes de mesure (16a, 16b), dans lequel n est un nombre entier naturel quelconque, dans lequel les mesures suivantes sont mises en oeuvre pour l'étalonnage :

   - n mesures d'étalonnage,
   où un signal de générateur en peigne est amené séquentiellement à toutes les n portes de mesure (16a, 16b) au moyen d'une ligne de liaison,
   où le signal de générateur en peigne est une somme de plusieurs signaux sinusoïdaux présentant un écart de fréquence équidistant,
   **caractérisé en ce que**
   la phase des différents signaux du signal de générateur en peigne est mesurée séquentiellement et de façon simultanée en un point de mesure sur le générateur en peigne ($m_5$) et en un point de mesure de la porte de mesure respective,
   dans lequel un déphasage dépendant de la fréquence des différents signaux est déterminé à partir des phases mesurées,
   - une mesure d'étalonnage,
   où toutes les n portes de mesure (16a, 16b) sont fermées au moyen de premières impédances d'entrée (67) identiques respectivement connues aux propriétés de transmission quelconques,
   où toutes les n portes de mesure sont excitées séquentiellement à toutes les fréquences du signal de générateur en peigne au moyen d'un oscillateur d'émission.

2. Procédé selon la revendication 1,
   **caractérisé par**

   - une autre mesure d'étalonnage,
   où toutes les n portes de mesure (16a, 16b) sont fermées au moyen de deuxièmes impédances d'entrée (87) identiques respectivement connues aux propriétés de transmission quelconques, qui sont différentes des premières impédances d'entrée,
   où toutes les n portes de mesure sont excitées séquentiellement à toutes les fréquences du signal de générateur en peigne au moyen d'un oscillateur d'émission, et
   - une autre mesure d'étalonnage,
   où toutes les n portes de mesure (16a, 16b) sont fermées au moyen de troisièmes impédances d'entrée (107) identiques respectivement connues aux propriétés de transmission quelconques, qui sont différentes des premières et des deuxièmes impédances d'entrée,
   où toutes les n portes de mesure sont excitées séquentiellement à toutes les fréquences du signal de générateur en peigne au moyen d'un oscillateur d'émission.

3. Procédé selon la revendication 1 ou 2,
   **caractérisé**
   **en ce que** la variation de fréquence de la puissance du signal de générateur en peigne est connue et stable à long terme.

4. Procédé selon la revendication 1 ou 2,
   **caractérisé**
   **en ce que** la variation de fréquence de la puissance du signal de générateur en peigne n'est pas connue et/ou n'est pas stable à long terme, et
   **en ce que** les mesures additionnelles suivantes sont mises en oeuvre :

   - n mesures d'étalonnage,
   où toutes les n portes de mesure (16a, 16b) sont reliées de manière consécutive à un dispositif de mesure de puissance (127), dans lequel la puissance de l'arbre sortant de la porte de mesure (16a, 16b) est mesurée,
   où toutes les n portes de mesure, séquentiellement, sont excitées de manière consécutive à toutes les fréquences du signal de générateur en peigne au moyen d'un oscillateur d'émission.

5. Procédé selon l'une quelconque des revendications 1 à 4,
**caractérisé**
**en ce que** des paramètres de réflexion et des paramètres de transmission sont mesurés sur toutes les connexions (18, 19) de l'analyseur de réseau vectoriel reliées aux portes de mesure (16a, 16b),
**en ce que** des réseaux d'erreurs (13, 14) sont calculés à partir des paramètres de réflexion et des paramètres de transmission mesurés et du déphasage,
**en ce que** les réseaux d'erreurs (13, 14) sont représentés par des matrices, lesquelles contiennent les données nécessaires à un calcul de la correction de valeurs brutes de mesure.

6. Procédé selon l'une quelconque des revendications 1 à 4,
**caractérisé**
**en ce que** des paramètres de réflexion et des paramètres de transmission sont mesurés sur toutes les connexions (18, 19) de l'analyseur de réseau vectoriel reliées aux portes de mesure (16a, 16b),
**en ce que** des réseaux d'erreurs (13, 14) sont calculés à partir des paramètres de réflexion et des paramètres de transmission mesurés et du déphasage et des puissances des arbres sortant des portes de mesure,
**en ce que** les réseaux d'erreurs (13, 14) sont représentés par des matrices, lesquelles contiennent les données nécessaires à un calcul de la correction de valeurs brutes de mesure.

7. Procédé selon l'une quelconque des revendications 1 à 6,
**caractérisé**
**en ce que** l'oscillateur d'émission (10) est couplé à un oscillateur de référence (22),
**en ce que** le générateur en peigne (12, 146) est couplé au même oscillateur de référence (22).

8. Procédé selon l'une quelconque des revendications 1 à 7,
**caractérisé**
**en ce que** les étalons (67, 87, 107) et/ou le générateur en peigne (12, 146) sont connectés électroniquement par l'intermédiaire d'une unité d'étalonnage automatique au moyen d'un commutateur.

9. Procédé selon la revendication 4,
**caractérisé**
**en ce qu'**un dispositif de mesure de puissance (127) est connecté électroniquement par l'intermédiaire d'une unité d'étalonnage automatique au moyen d'un commutateur.

10. Dispositif d'étalonnage d'analyseurs de réseau vectoriels, lesquels disposent de n portes de mesure (16a, 16b), au moyen de plusieurs étalons (67, 87, 107, 146) différents
dans lequel le dispositif met en oeuvre plusieurs mesures d'étalonnage,
dans lequel les différents étalons (67, 87, 107, 146) sont connectés aux portes de mesure (16a, 16b),
dans lequel n est un nombre entier naturel quelconque, dans lequel le dispositif d'étalonnage met en oeuvre les mesures suivantes :

- n mesures d'étalonnage,
où un signal de générateur en peigne est amené successivement à toutes les n portes de mesure (16a, 16b) au moyen d'une ligne de liaison,
où le signal de générateur en peigne est une somme de plusieurs signaux sinusoïdaux présentant un écart de fréquence équidistant,
**caractérisé en ce que**
le dispositif mesure séquentiellement la phase des différents signaux du signal de générateur en peigne de façon simultanée en un point de mesure sur le générateur en peigne ($m_5$) et en un point de mesure de la porte de mesure respective,
dans lequel le dispositif détermine à partir des phases mesurées un déphasage dépendant de la fréquence,
- une mesure d'étalonnage,
où toutes les n portes de mesure (16a, 16b) sont fermées au moyen de premières impédances d'entrée (67) identiques respectivement connues aux propriétés de transmission quelconques,
où le dispositif excite séquentiellement toutes les n portes de mesure de manière consécutive à toutes les fréquences du signal de générateur en peigne au moyen d'un oscillateur d'émission.

**11.** Dispositif selon la revendication 10,
**caractérisé**
**en ce que** le dispositif met en oeuvre d'autres mesures d'étalonnage suivantes :

- une mesure d'étalonnage,
où toutes les n portes de mesure (16a, 16b) sont fermées au moyen de deuxièmes impédances d'entrée (87) identiques respectivement connues aux propriétés de transmission quelconques, qui sont différentes des premières impédances d'entrée,
où le dispositif excite séquentiellement toutes les n portes de mesure à toutes les fréquences du signal de générateur en peigne au moyen d'un oscillateur d'émission, et
- une mesure d'étalonnage,
où toutes les n portes de mesure (16a, 16b) sont fermées au moyen de troisièmes impédances d'entrée (107) identiques respectivement connues aux propriétés de transmission quelconques, qui sont différentes des premières et des deuxièmes impédances d'entrée,
où le dispositif excite séquentiellement toutes les n portes de mesure de manière consécutive à toutes les fréquences du signal de générateur en peigne au moyen d'un oscillateur d'émission.

**12.** Dispositif selon la revendication 10 ou 11,
**caractérisé**
**en ce que** la variation de fréquence de la puissance du signal de générateur en peigne est connue et stable à long terme.

**13.** Dispositif selon la revendication 10 ou 11,
**caractérisé**
**en ce que** la variation de fréquence de la puissance du signal de générateur en peigne n'est pas connue et/ou n'est pas stable à long terme, et
**en ce que** le dispositif met en oeuvre les mesures additionnelles suivantes :

- n mesures d'étalonnage,
où le dispositif relie séquentiellement toutes les n portes de mesure (16a, 16b) à un dispositif de mesure de puissance (127), dans lequel la puissance de l'arbre sortant de la porte de mesure (16a, 16b) est mesurée,
où le dispositif excite séquentiellement toutes les n portes de mesure de manière consécutive au moyen d'un oscillateur d'émission à toutes les fréquences du signal de générateur en peigne.

**14.** Dispositif selon l'une quelconque des revendications 10 à 13,
**caractérisé**
**en ce que** le dispositif mesure des paramètres de réflexion et des paramètres de transmission sur toutes les connexions (18, 19) de l'analyseur de réseau vectoriel reliées aux portes de mesure (16a, 16b),
**en ce que** le dispositif comprend une unité de calcul, qui calcule les réseaux d'erreurs (13, 14) à partir des paramètres de réflexion et des paramètres de transmission mesurés et du déphasage,
dans lequel les réseaux d'erreurs (13, 14) sont représentés par des matrices, lesquelles contiennent les données nécessaires à un calcul de la correction de valeurs brutes de mesure.

**15.** Dispositif selon l'une quelconque des revendications 10 à 13,
**caractérisé**
**en ce que** le dispositif mesure des paramètres de réflexion et des paramètres de transmission sur toutes les connexions (18, 19) de l'analyseur de réseau vectoriel reliées aux portes de mesure (16a, 16b),
**en ce que** le dispositif comprend un système de calcul qui calcule des réseaux d'erreurs (13, 14) à partir des paramètres de réflexion et des paramètres de transmission mesurés, du déphasage et des puissances des arbres sortant des portes de mesure,
dans lequel les réseaux d'erreurs (13, 14) sont représentés par des matrices, lesquelles contiennent les données nécessaires à un calcul de la correction des valeurs brutes de mesure.

**16.** Dispositif selon l'une quelconque des revendications 10 à 15,
**caractérisé**
**en ce que** l'oscillateur d'émission (10) est couplé à un oscillateur de référence (22),
**en ce que** le générateur en peigne (12, 146) est couplé au même oscillateur de référence (22).

**17.** Dispositif selon l'une quelconque des revendications 10 à 16,
**caractérisé**
**en ce que** le dispositif connecte de manière électroniquement commandée les étalons (67, 87, 107) et/ou le générateur en peigne (12, 146) par l'intermédiaire d'une unité d'étalonnage automatique au moyen d'un commutateur.

**18.** Dispositif selon l'une quelconque des revendications 10 à 17,
**caractérisé**
**en ce que** le dispositif connecte électroniquement un dispositif de mesure de puissance (127) par l'intermédiaire d'une unité d'étalonnage automatique au moyen d'un commutateur.

## Fig. 1

## Fig. 2

**Fig. 3**

**Fig. 4**

**Fig. 5**

**Fig. 6**

EP 2 156 202 B1

Fig. 7

22

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19918960 A1

- DE 19918697 A1

**In der Beschreibung aufgeführte Nicht-Patentliteratur**

- Mixer-Based, Vector-Corrected, Vector Signal/Network Analyzer Offering 300kHz-20GHz Bandwidth and Traceable Phase Response. **BLOCKLEY P. et al.** MICROWAVE SYMPOSIUM DIGEST, 2005 IEEE MTT-S INTERNATIONAL LONG BEACH. IEEE, 12. Juni 2005, 1497-1500
- Wide-Bandwidth, Vector-Corrected Measurement with High Spurious-Free Dynamic Range. **BLOCKLEY P. et al.** ARFTG CONFERENCE DIGEST, 2005. SPRING 2005. 65TH LONG BEACH. IEEE, 17. Juni 2005, 175-178

- Measurement of Time-Domain Voltage/Current Waveforms at RF and Microwave Frequencies Based on the USE of a Vector Network Analyzer for the Characterization of Nonlinear Devices-Application to High-Efficiency Power Amplifiers and Frequency-Multipliers Optimization. **DENIS BARATAUD et al.** IEEE TRANSACTIONS ON INSTRUMENTATION AND MEASUREMENT. IEEE SERVICE CENTER, 01. Oktober 1998
- A New Instrument Architecture for Millimetre-Wave Time-Domain Signal Analysis. **SCOTT J. B. et al.** ARFTG 63RD CONFERENCE, SPRING 2004 FORT WORTH. IEEE, 01. Januar 2004, 47-52
- **P. BLOCKLEY ; D. GUNYAN ; J. B. SCOTT.** Mixer-based, vector-corrected, vector signal/network analyzer offering 300kHz-20GHz. *IEEE MTT-S,* Juni 2005